Europäisches Patentamt

European Patent Office

Office européen des brevets

(19)

(11) **EP 0 390 175 B1**

(12) **EUROPEAN PATENT SPECIFICATION**

(45) Date of publication and mention
of the grant of the patent:
**24.07.1996 Bulletin 1996/30**

(51) Int Cl.6: **G01R 33/56**, G01R 33/485

(21) Application number: **90106081.4**

(22) Date of filing: **29.03.1990**

(54) **Multi-echo NMR imaging method**

Multi-Echo-NMR-Abbildungsverfahren

Procédé multi-écho d'imagerie RMN

(84) Designated Contracting States:
**DE GB**

(30) Priority: **31.03.1989 JP 78228/89**

(43) Date of publication of application:
**03.10.1990 Bulletin 1990/40**

(73) Proprietor: **HITACHI, LTD.**
**Chiyoda-ku, Tokyo 100 (JP)**

(72) Inventors:
• **Nozokido, Tatsuo, Hitachi Daini Kyoshinryo**
**Kokubunji-shi (JP)**
• **Yamamoto, Etsuji**
**Akishima-shi (JP)**
• **Kohno, Hideki**
**Tama-shi (JP)**

(74) Representative:
**Strehl Schübel-Hopf Groening & Partner**
**Maximilianstrasse 54**
**80538 München (DE)**

(56) References cited:
EP-A- 0 226 247          JP-A-64 025 842
US-A- 4 628 262          US-A- 4 833 408

• MAGNETIC RESONANCE IN MEDICINE. vol. 5,
no. 1, July 1987, DULUTH,MN US pages 83 - 86;
J.A.B. LOHMAN ET AL.: "Spin echo imaging of
multiple chemical shifts"
• PHYSICS IN MEDECINE AND BIOLOGY. vol. 31,
no. 7, July 1986, LONDON GB pages 713 - 720;
E. YAMAMOTO ET AL.: "Resolution of NMR
chemical shift images into real and imaginary
components"
• RADIOLOGY vol. 159, no. 3, June 1986, pages
783 - 786; H.N. YEUNG ET AL.: "Separation of
true fat and water images by correcting magnetic
field inhomogeneity in situ"

**Description**

BACKGROUND OF THE INVENTION

The present invention relates to a method of providing a hydrogen or phosphorus distribution image of an object to be examined by use of a nuclear magnetic resonance (NMR) phenomenon, and more particularly to an imaging method of obtaining separative distribution images for two chemical shift exhibiting substances for a short time.

In an NMR imaging in which spins of atomic nuclei of hydrogen are to be examined, an image representative of the distribution of water contents in a living body and an image representative of the distribution of fat contents therein are separately obtained to increase the quantity of information necessary for diagnosis. There are known some approachs to obtain separative magnetization distribution images for two kinds of substances, in an object to be examined, which exhibit known chemical shifts. Radiology, Vol. 159 (1986), pp. 783-789 discloses a method using a multi-echo sequence which produces first and second echoes. This method includes a measurement based on a first multi-echo sequence in which chemical shift effects for the phases of two kinds of spins are cancelled for each of first and second echoes and a measurement based on a second multi-echo sequence in which a first echo produces a difference of $\pi$ between the phase shift effects for the two kinds of spins and a second echo produces a difference of $2\pi$ therebetween. Separative images are determined from four images which are obtained by such a method. U.S. Patent No. 4,739,265, a part of the inventors of which are the same as a part of the inventors of the present application, proposes a method of obtaining two separative images by solving simultaneous equations of the real and imaginary parts of NMR image data acquired through a measurement sequence which produces a difference of $\pi/2$ or $(2n + 1)\pi/2$ ($n = 0, 1, 2, 3$ ---) between the phase shift effects for two kinds of spins to be separated from each other.

What is common to the two conventional methods mentioned above is that phase encoding is used for a mapping in a first direction and a read-out gradient is used for a mapping in a second direction. Accordingly, as well known, the measurement sequence must be repeated $\underline{n}$ times while changing the value of integration of the phase encoding gradient with respect to time in $\underline{n}$ ways, in order to obtain images having $\underline{n}$ pixels for the first direction. In the former of the above two conventional methods, since such a consecutive repetition of the measurement sequence is performed for each of the two kinds of multi-echo sequence, there is involved a drawback that an object to be examined is placed under restraint within the NMR apparatus for a long time.

SUMMARY OF THE INVENTION

In the latter of the above two conventional methods, the measurement of an NMR image of a homogeneous phantom containing one kind of spins is additionally performed in order to eliminate the effect or influence of static magnetic field inhomogeneity which appears as the result of shift in spin phase in a similar manner to the effect of chemical shift. The thus acquired data concerning the static magnetic field inhomogeneity is used to eliminate a static magnetic field inhomogeneity-induced phase error contained in an image of an object to be examined which is obtained from the above-mentioned specified measurement sequence. However, the object to be imaged has a magnetic permeability distribution of its own. Strictly speaking, therefore, the static magnetic field inhomogeneity changes each one specified object to be examined is inserted into the NMR apparatus. In other words, though the static magnetic field inhomogeneity detected by the measurement of the NMR image of the homogeneous phantom can be regarded as being the inhomogeniety of a static magnetic applied to the object from the NMR apparatus, the phase of spins upon measurement of the object encounters in combination the effect of chemical shift, the effect of the inhomogeneity of the externally applied static magnetic field, and the effect of a change in magnetic flux density depending on the magnetic permeability distribution of the object. As a result, it has been revealed that the conventional method as mentioned above has a problem that the quantifiability or estimability of separative images for two kinds of chemical shifts is deteriorated since the phase shift induced by the change in magnetic flux density cannot be removed.

JP-A-64-025842 describes an NMR imaging method including the features of the first part of claim 1. Physics in Medicine & Biology Vol. 31, no. 7, July 1986, pages 713-720 discloses an NMR imaging method, wherein the data of a second measurement of a reference material with a single resonant line is used to eliminate a phase error distribution caused by a static field inhomogeneity.

The object of the present invention is to provide an NMR imaging method which requires a short time of restraint of an object to be examined for measurement thereof and is capable of obtaining separative images which have excellent quantifiability or estimability, that is, images in which two kinds of spins exhibiting different chemical shifts are accurately separated from each other, which NMR imaging method is capable of easily eliminating phase error components in images and in which a phase error caused by a change in magnetic flux density depending on the magnetic permeability distribution of an object to be examined is also eliminated.

The present invention employs a multi-echo sequence in which two or more echoes are generated (or echoes are generated two or more times) after one spin excitation. What is the most characteristic of the present invention includes performing a consecutive measurement of an object with successive alteration in phase encode value through a multi-echo sequence in which a phase difference of $\theta_1 \neq n\pi$ and a phase difference of $\theta_2 = 2n\pi$ ($n = \pm1, \pm2, \text{---}$) are respectively produced for a first echo and a second echo between two kinds of spins to be separated from each other, that is, spins exhibiting a chemical shift $\sigma_1$ and spins exhibiting a chemical shift $\sigma_2$, deriving first and second complex images from the first and second echoes, respectively, correcting the phase of the first image by converting a phase distribution of the second image into a distribution of phase error components contained in the first image which are caused by a static magnetic field inhomogeneity, and obtaining separative images for the two kinds of spins from real and imaginary parts of the first image corrected.

At each pixel point of the second image, the vectors of the two kinds of spins take the same direction or sense. Therefore, if an offset phase inherent to the apparatus is ignored, the phase distribution of the second image represents a phase error distribution caused by the static magnetic field inhomogeneity. On the other hand, a composite signal at each pixel point of the first image shows a vector in which the phase error distribution induced by the static magnetic field inhomogeneity is added to the composite vector of respective vectors of the two kinds of spins having different directions or senses. Accordingly, the phase error distribution in the first image can be reduced from the phase distribution of the second image and the complex image after having been subjected to the phase error correction results in an image representing the distribution of composite vectors of the two kinds of spins.

Especially, provided that the phase difference $\theta_1$ is $\pi/2$ or $(2n + 1)\pi/2$ and if the offset phase inherent to the apparatus is removed from the first image corrected, the real and imaginary parts of the obtained complex image provide magnetization distribution images of the two kinds of spins to be separated from each other as they are.

According to the method of the present invention as mentioned above, the phase error distribution obtained from the second image shows a static magnetic field inhomogeneity obtained in a state in which an object to be examined is actually inserted in the NMR apparatus. Namely, irrespective of a specified magnetic permeability distribution possessed by the object inserted in the NMR apparatus, the phase error distribution obtained from the second image shows an effective static magnetic field inhomogeneity which includes a change in magnetic flux density caused by the insertion of the object in the NMR apparatus. Accordingly, a complex image obtained by correcting the phase error distribution accurately shows the distribution of composite vectors of the two kinds of spins.

In the case where the static magnetic field inhomogeneity is large and a phase error distribution caused by the large static magnetic field inhomogeneity exceeds a range of $\pm\pi$, a phase distribution image of the second image includes discontinuous points which are produced due to aliasing. In such a case, it is necessary to make a correction for aliasing through observation of the phase distribution of the second image prior to conversion into a phase error distribution. Claim 1 characterises a method for obtaining an image of a homogeneous phantom by the same measurement sequence as that for the measurement of the object to be examined, to eliminate phase errors caused by the static magnetic field distribution (which does not contain a change in magnetic flux density depending on a magnetic permeability distribution of the object to be examined) from the above-mentioned first and second images by use of the phantom image so that the remaining phase error contained in each of the first and second images is only a phase error caused by the change in magnetic flux density, and the above-mentioned correction for the phase error components by the phase distribution of the second image is thereafter performed.

BRIEF DESCRIPTION OF THE DRAWINGS

Fig. 1 is a time chart of a measurement sequence according to an embodiment of the present invention;

Fig. 2 is a flow chart illustrating a processing performed in the embodiment;

Figs. 3 and 4 are cenceptual diagrams showing examples of correction for phase aliasing; and

Fig. 5 is a flow chart illustrating a processing performed in another embodiment of the present invention.

DESCRIPTION OF THE PREFERRED EMBODIMENTS

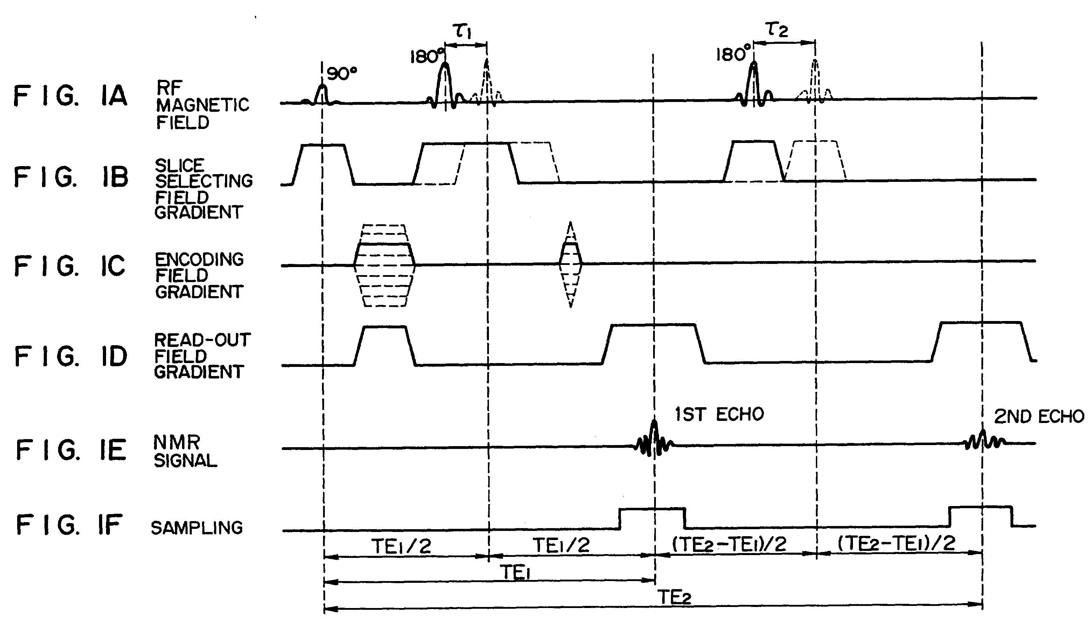

Figs. 1A to 1F show a pulse sequence used for measurement of an NMR signal of an object to be examined in an embodiment of the present invention. Fig. 1A shows the waveform of a radio frequency (RF) magnetic field additionally superimposed on a static magnetic field applied to a field of view for measurement, that is, a specified space in which the object to be examined is inserted. Figs. 1B, 1C and 1D show the temporal changes of field gradients providing, to the intensity of the static magnetic field, gradients along three orthogonal $\underline{z}$, $\underline{x}$ and $\underline{y}$ directions which are called a slice selecting gradient, an encoding gradient and a read-out gradient, respectively. In Figs. 1A and 1B, the conventional multi-echo sequence in which the separation by chemical shifts is not effected is shown for comparison by broken lines. Solid lines show a multi-echo sequence according to the present embodiment having 180° RF pulses the timings of application of which are shifted from those in the conventional multi-echo sequence.

First, a slice selecting gradient is applied together with a 90° RF pulse to excite spins in a specified slice perpendicular to the $\underline{z}$ direction. A first 180° RF pulse having a peak at the point of time after the lapse of a time $TE_1/2 - \tau_1$

from the point of time of peak of the 90° RF pulse (or time origin) is applied together with a slice selecting gradient. Though the peak of a Hahn echo by the first 180° RF pulse is produced at the point of time after the lapse of a time $TE_1 - 2\tau_1$ from the time origin, the peak of the first echo or a gradient echo actually produced by the generation of a read-out gradient as shown in Fig. 1C appears at the point of time after the lapse of a time $TE_1$ from the time origin. A difference in phase between spins exhibiting different chemical shifts is produced in a period of time which corresponds to a time difference $2\tau_1$ between the Hahn echo and the gradient echo. In the present embodiment, $\tau_1$ is selected such that a phase difference of $\theta_1 = \pi/2$ is produced between two chemical shifts $\sigma_1$ and $\sigma_2$ (in units of ppm) to be separated from each other. Next, a second 180° RF pulse having a peak at the point of time after the lapse of a time $(TE_2 - TE_1)/2 - \tau_2$ from the peak of the first echo is applied to produce a second echo. In this case, too, a read-out gradient is generated so that the peak of the second echo or a gradient echo actually produced appears at the point of time after the lapse of a time $TE_2 - TE_1$ from the first echo. For the second echo, therefore, a time difference between a Hahn echo and the gradient echo is $2(\tau_2 - \tau_1)$. The value of $\tau_2$ is set such that a phase difference of $\theta_2 = 2\pi$ is produced between the two chemical shifts in the time difference of $2(\tau_2 - \tau_1)$. In general, $\tau_1$ and $\tau_2$ are set so as to satisfy the relation of

$$\left. \begin{array}{c} \theta_1 \neq n\pi \\[2em] \theta_2 = 2n\pi \end{array} \right\} \qquad \ldots\ldots \quad (1)$$

($n = \pm 1, \pm 2, ---$) The first and second echoes shown in Fig. 1E are respectively measured in periods of time shown in Fig. 1F or the periods of time when the read-out gradients are generated.

The above measurement sequence is repeated while successively altering the magnitudes of the encoding gradient shown in Fig. 1C, thereby acquiring a series of data containing information for spin mapping in the $\underline{x}$ and $\underline{y}$ directions for each of the first and second echoes.

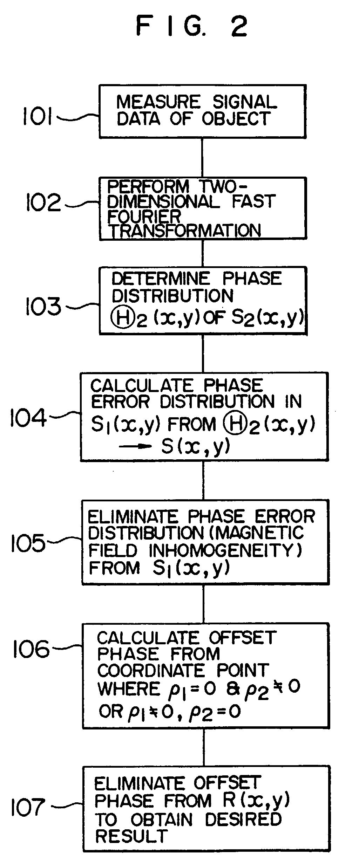

Fig. 2 shows in flow chart the whole of an imaging method in the present embodiment. In step 101, an object to be examined is inserted in a field of view for measurement and data measurement is made by the above-mentioned consecutive measurement sequence. Next, in step 102, two-dimensional Fourier transformations are performed for a series of data acquired for the first echo and a series of data acquired for the second echo, respectively, to obtain a first complex image $S_1(x, y)$ and a second complex image $S_2(x, y)$. The first and second complex images can be represented by

$$\left. \begin{array}{l} S_1(x, y) = \{\rho_1(x, y) + \rho_2(x, y) \exp(j\theta_1)\} \\[1em] \qquad\qquad \times \exp\{-j\gamma[E(x, y) + \sigma_1]\tau_1 + j\theta_1'\} \\[1em] S_2(x, y) = \{\rho_1'(x, y) + \rho_2'(x, y) \exp(j\theta_2)\} \\[1em] \qquad\qquad \times \exp\{-j\gamma[E(x, y) + \sigma_1]\tau_2 + j\theta_2'\} \end{array} \right\} \cdot$$

$$\ldots\ldots \quad (2)$$

In the equation (1), $\rho_1(x, y)$ and $\rho_2(x, y)$ show the magnetization distributions of substances having the chemical shifts $\sigma_1$ and $\sigma_2$, that is, the density distributions of those substances, respectively. However, since a lateral relaxation time of magnetization for the second echo is in advance of that for the first echo, the equation for the second image $S_2(x, y)$ based on the second echo includes magnetization distributions represented by $\rho_1'(x, y)$ and $\rho_2'(x, y)$. In the equation (1), $\gamma$ is the gyromagnetic ratio, $\theta_1'$ and $\theta_2'$ are fixed phases which do not depend on coordinates, and $E(x, y)$ is the magnetic field inhomogeneity in the object to be examined.

Especially, provided that $\theta_1 = \pi/2$ and $\theta_2 = 2\pi$, as shown regarding the above-mentioned example, the first and second images can be represented by

$$S_1(x, y) = \{\rho_1(x, y) + j\rho_2(x, y)\}$$
$$\times \exp\{-j\gamma[E(x, y) + \sigma_1]\tau_1 + j\theta_1'\}$$
$$S_2(x, y) = \{\rho_1'(x, y) + \rho_2'(x, y)\}$$
$$\times \exp\{-j\gamma[E(x, y) + \sigma_1]\tau_2 + j\theta_2'\}.$$

$$\quad\quad\quad \ldots\ldots \quad (3)$$

Namely, in each pixel of the second image, the vectors of the two kinds of spins take the same direction or sense and the second image contains only a phase error $-\gamma E(x, y)$ caused by the static magnetic field inhomogeneity $E(x, y)$ if a phase term corresponding to one $\sigma_1$ of the chemical shifts and an offset phase are ignored.

Next, in step 103, a phase distribution $\theta_2(x, y)$ of the second image $S_2(x, y)$ is determined by the equation

$$\theta_2(x, y) = \tan^{-1}\{Im[S_2(x,y)]/Re[S_2(x, y)]\} \quad\quad (4)$$

wherein $Im[S_2(x, y)]$ is the imaginary part of the second image and $Re[S_2(x, y)]$ is the real part of the second image. The phase distribution $\theta_2(x, y)$ can be rewritten from the equation (3) as follows;

$$\theta_2(x, y) = -\gamma[E(x, y) + \sigma_1]\tau_2 + \theta_2'. \quad\quad (5)$$

Next, in step 104, a conversion according to the following equation (6) is made for the obtained phase image $\theta_2(x, y)$ to determine an error distribution $S(x, y)$ contained in the first image which is caused by the static magnetic field inhomogeneity.

$$S(x, y) = \exp\{j(\tau_1/\tau_2)\theta_2(x, y)\}. \quad\quad (6)$$

The thus obtained $S(x, y)$ can be represented from the equations (5) and (6) as follows:

$$S(x, y) = \exp\{-j\gamma[E(x, y) + \sigma_1]\tau_1 + (\tau_1/\tau_2)\theta_2'\}. \quad\quad (7)$$

Next, in step 105, a product of the vector $S_1(x, y)$ of each pixel point of the first image and the complex conjugate vector $S^*(x, y)$ of each pixel point of the phase error distribution $S(x, y)$ is made to obtain a new image $R(x, y)$ in which the phase error caused by the static magnetic field inhomogeneity is eliminated from the first image. Namely, $R(x, y)$ is represented by the following equation:

$$R(x, y) = S_1(x, y) \times S^*(x, y)$$

$$= \{\rho_1(x, y) + j\rho_2(x, y)\}$$

$$\times \underline{\exp\{j(\theta_1' - (\tau_1/\tau_2)\theta_2')\}}. \quad\quad (8)$$

If an offset phase underlined in the equation (8) is eliminated, a desired separation image $T(x, y)$ shown by the following equation (9) is obtained.

$$T(x, y) = \rho_1(x, y) + j\rho_2(x, y). \quad\quad (9)$$

For that purpose, in step 106, the image $R(x, y)$ is searched for a phase $\theta_{off}$ at the coordinate $(x, y)$ where $\rho_1 = 0$ and $\rho_2 \neq 0$ or $\rho_1 \neq 0$ and $\rho_2 = 0$. The phase $\theta_{off}$ is termed $\theta_R'$. For example, the complex vector $R'(x, y)$ of the coordinate $(x, y)$ providing $\rho_1 \neq 0$ and $\rho_2 = 0$ is as follows:

$$R'(x, y) = \rho_1(x, y) \exp\{j(\theta_1' - (\tau_1/\tau_2)\theta_2')\}. \quad\quad (10)$$

The phase term $\theta_R'$ of the equation (10) is as follows:

$$\theta_R' = \theta_{off} - \theta_1'(\tau_1/\tau_2)\theta_2'. \quad\quad (11)$$

Accordingly, in step 107, the determined $\theta_R'$ is used to eliminate the offset phase from the image $T(x, y)$ in accordance with the following equation:

$$T(x, y) = R(x, y) \times \exp(-j\theta_R'). \quad\quad (12)$$

Since the complex image $T(x, y)$ thus obtained assumes the equation (9), the real part of the complex image $T(x, y)$

represents the spin density distribution $\rho_1(x, y)$ of the chemical shift $\sigma_1$ and the imaginary part thereof represents the spin density distribution $\rho_2(x, y)$ of the chemical shift $\sigma_2$.

The above is the flow of an image processing for obtaining separative images from two images which are obtained through the measurement of one time for an object in accordance with the multi-echo sequence shown in Fig. 1. What gives rise to a problem in the above processing is the operation of producing $S(x, y)$ shown by the equation (6). Namely, in the case where $E(x, y)$ is so small that the equation (5) actually satisfies the relation of

$$-\pi \leqq \theta_2(x, y) \leqq +\pi , \qquad\qquad (13)$$

$S(x, y)$ can be simply calculated by the equation (7). However, as $E(x, y)$ becomes larger, $\theta_2(x, y)$ does not actually satisfy the relation (13) though it apparently satisfies the relation (13). The reason is that $\theta_2(x, y)$ is calculated by the equation (4) and does never take values other than $-\pi \leqq \theta_2(x, y) \leqq \pi$ or $0 \leqq \theta_2(x, y) \leqq 2\pi$. In the case where the static mangetic field inhomogeneity is so large that the relation (13) is not satisfied, the phase image of $S_2(x, y)$ gives rise to aliasing. Namely, if the phase image $\theta_2(x, y)$ is displayed, an abrupt phase change from $-\pi$ to $\pi$ or from $\pi$ to $-\pi$ appears between adjacent coordinate points.

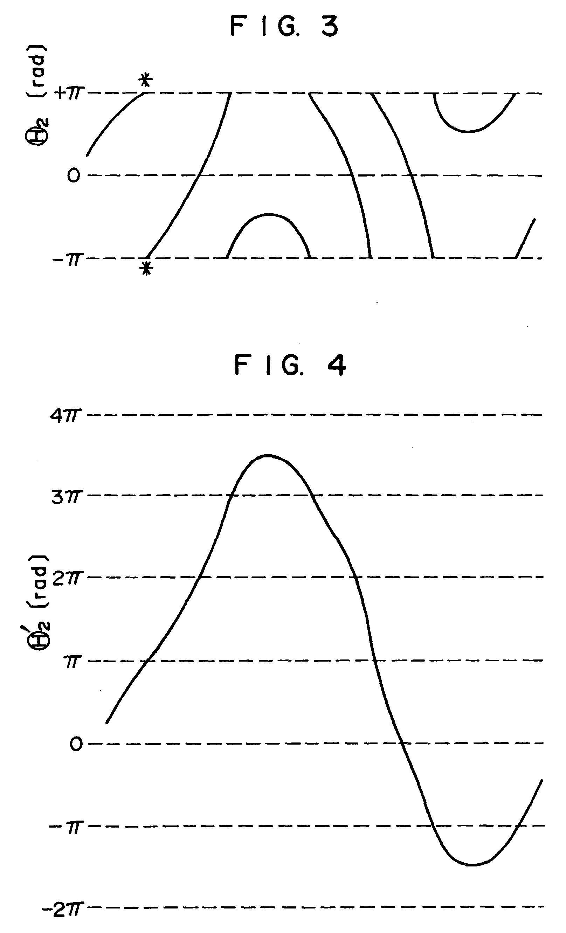

A certain one-dimensional value of $\Theta_2(x, y)$ in such a case provides a representation as shown in Fig. 3. A change from $+\pi$ to $-\pi$ occurs at a location indicated by * in Fig. 3. In the case where the relation (13) is not satisfied, that is, in the case where $\theta_2(x, y)$ takes such a form as shown in Fig. 3, the calculation of the equation (6) is performed after the conversion of $\theta_2$ into $\theta_2'$ as shown in Fig. 4 has been made to provide the continuity of phase, considering that a spacial change of $E(x, y)$ is smooth or $E(x, y)$ continuously changes. Namely, in place of $S(x, y)$ shown by the equation (6) is used $S(x, y)$ according to the following equation:

$$S(x, y) = \exp \{j(\tau_1/\tau_2)\theta_2'(x, y)\} . \qquad\qquad (14)$$

Figs. 3 and 4 show a phase change in one dimension. In actual, however, since $\theta_2(x, y)$ is two-dimensional, a two-dimensional phase continuity processing is required.

In many cases, a calculation processing for making the two-dimensional phase continuity not only becomes complicated but also is hard to be successfully executed, for example, when the object to be examined is a complicated structure such as a human body.

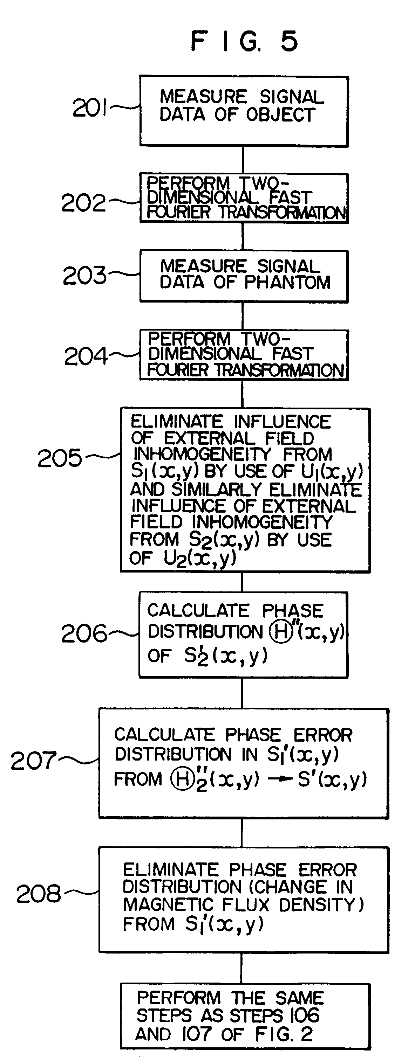

A second embodiment of the present invention in which such a calculation processing is avoided will now be explained in reference to Fig. 5. The measurement of an object performed in step 201 and two-dimensional Fourier transformation performed in step 202 are quite similar to those in steps 101 and 102 in the first embodiment shown in Fig. 2. Thus, two complex images $S_1(x, y)$ and $S_2(x, y)$ are obtained. Next, in step 203, a phantom having a larger cross section than that of the object and containing uniformly only a substance exhibiting one chemical shift $\sigma_r$ is measured by the sequence shown in Figs. 1A-1F, just like the case of the measurement of the object. Next, in step 204, a series data acquired for a first echo and a series of data acquired for a second echo are subjected to two-dimensional Fourier transformations, respectively, to obtain complex images $U_1(x, y)$ and $U_2(x, y)$. These images $U_1(x, y)$ and $U_2(x, y)$ are represented by the following equation (15) corresponding to the equation (3):

$$
\left.
\begin{aligned}
U_1(x, y) &= \rho_r(x, y) \exp \{-j\gamma[E_{st}(x, y) \\
&\qquad + \sigma_r]\tau_1 + j\theta_r\} \\
U_2(x, y) &= \rho_r'(x, y) \exp \{-j\gamma[E_{st}(x, y) \\
&\qquad + \sigma_r]\tau_2 + j\theta_r'\}
\end{aligned}
\right\} \quad \ldots\ldots \quad (15)
$$

wherein $\rho_r(x, y)$ and $\rho_r'(x, y)$ are the density distributions of the substance exhibiting the chemical shift $\sigma_r$ in which the influence of lateral relaxation of magnetization is taken into consideration, like the case of the equation (3), $\theta_r$ and $\theta_r'$ are fixed phases which do not depend on coordinates, and $E_{st}(x, y)$ is the magnetic field inhomogeneity in the phantom which can be regarded as being the inhomogeneity of a static magnetic field externally applied to the object in the case where the phantom is sufficiently larger than the object.

Next, in step 205, $U_1$ and $U_2$ are used so that $S_1$ and $S_2$ of the equation (3) are subjected to the following operation (16) to eliminate from the images $S_1$ and $S_2$ a phase distribution which is caused by the inhomogeneity $E_{st}(x, y)$ of a static magnetic field applied:

$$S_1{}'(x, y) = S_1(x, y) \times U_1{}^*(x, y)/|U_1(x,y)|$$

$$= \{\rho_1(x, y) + j\rho_2(x, y)\}$$

$$\times \exp\{-j\gamma[E_{per}(x, y) + (\sigma_1 - \sigma_r)]\tau_1$$

$$+ j(\theta_1{}' - \theta_r{}')\}$$

$$S_2{}'(x, y) = S_2(x, y) \times U_2{}^*(x,y)/|U_2(x, y)|$$

$$= \{\rho_1{}'(x,y) + \rho_2{}'(x, y)\}$$

$$\times \exp\{-j\gamma[E_{per}(x, y) + (\sigma_1 - \sigma_r)]\tau_2$$

$$+ j(\theta_2{}' - \theta_r{}')\}$$

$$\ldots \ldots \quad (16)$$

wherein $E_{per}(x, y)$ represents a change in magnetic flux density depending on the magnetic permeability distribution of the object to be examined and satisfies the relation of $E(x, y) = E_{st}(x; y) + E_{per}(x, y)$ in connection with the magnetic field inhomogeneity $E(x, y)$ in the object to be examined.

Next, in step 206, there is determined a phase distribution $\theta''(x, y)$ of the image $S_2{}'(x, y)$ from which only the phase error caused by the inhomogeneity of the externally applied static magnetic field is eliminated. $\theta''(x, y)$ is represented by the following equation:

$$\theta_2{}''(x, y) = -\gamma[E_{per}(x, y) + (\sigma_1 - \sigma_r)]\tau_2$$

$$+ (\theta_2{}' - \theta_r{}')\}. \qquad (17)$$

The generally called static magnetic field inhomogeneity $E(x, y)$ is the sum of the inhomogeneity $E_{st}(x, y)$ of the static magnetic field externally applied to the object to be examined and the change $E_{per}(x, y)$ in magnetic flux density depending on the magnetic permeability distribution of the object to be examined. $E_{per}(x, y)$ is far smaller than $E_{st}(x, y)$. Accordingly, $\theta_2{}''(x, y)$ from which $E_{st}(x, y)$ is eliminated can practically satisfy the relation (13) at all coordinates $(x, y)$. Namely, the processing mentioned in conjunction with the first embodiment is not required.

Next, in step 207, the phase distribution $\theta_2{}''(x, y)$ is converted into a phase error distribution contained in the image $S'_1(x, y)$. Namely, in a similar manner to the equation (6), $S'(x, y)$ is determined by the following equation:

$$S'(x, y) = \exp\{j(\tau_1/\tau_2)\theta_2{}''(x, y)\}. \qquad (18)$$

Next, in step 208, a phase error contained in the image $S_1{}'(x, y)$ (or a phase error corresponding to the change in magnetic flux density depending on the permeability distribution of the object to be examined) is eliminated. Namely, there is obtained $R(x, y)$ according to the following equation:

$$R(x, y) = S_1{}'(x, y) \times S'^*(x, y)$$

$$= \{\rho_1(x, y) + j\rho_2(x, y)\}$$

$$\times \exp(J(\theta_1{}' - (\tau_1/\tau_2)\theta_2{}')\}$$

$$\times \exp\{j\theta_r{}'((\tau_1/\tau_2)-1)\}. \qquad (19)$$

Subsequently, steps similar to steps 106 and 107 shown in Fig. 2 in conjunction with the first embodiment are performed so that an offset phase is eliminated, thereby obtaining separative images $\rho_1(x, y)$ and $\rho_2(x, y)$.

As has been mentioned, the search for a phase at the coordinate $(x, y)$ where $\rho_1 = 0$ and $\rho_2 \neq 0$ or $\rho_1 \neq 0$ and $\rho_2$

= 0 must be made in order to eliminate the offset phase $\theta_{off}$. In order to eliminate the offset phase $\theta_{off}$ without performing such a processing, a reconstructed image is used which is obtained at timing when $\theta_1$ and $\theta_2$ are 0, respectively, that is, in accordance with the conventional multi-echo sequence. In the case where $\tau_1 = \tau_2 = 0$, that is, $\theta_1 = \theta_2 = 0$, $S_1(x, y)$ and $S_2(x, y)$ of the equation (3) can be written as $S_{10}(x, y)$ and $S_{20}(x, y)$ of the following equation:

$$
\left.
\begin{aligned}
S_{10}(x, y) &= S_1(x, y)|\theta_1 = 0 \\
&= \{\rho_1(x, y) + \rho_2(x, y)\}\exp(j\theta_1') \\
S_{20}(x, y) &= S_2(x, y)|\theta_2 = 0 \\
&= \{\rho_1(x, y) + \rho_2(x, y)\}\exp(j\theta_2').
\end{aligned}
\right\} \quad \ldots \quad (20)
$$

By use of $S_{10}(x, y)$ and $S_{20}(x, y)$, $\theta_1'$ and $\theta_2'$ are eliminated from the images shown by the equation (3) to obtain images $P_1$ and $P_2$ of the following equation:

$$
\left.
\begin{aligned}
P_1(x, y) &= S_1(x, y) \times S_{10}^*(x, y)/|S_{10}(x, y)| \\
&= \{\rho_1(x, y) + j\rho_2(x, y)\}\exp \\
&\quad \{-j\gamma[E(x,y) + \sigma_1]\tau_1\} \\
P_2(x, y) &= S_2(x, y) \times S_{20}^*(x, y)/|S_{20}(x, y)| \\
&= \{\rho'_1(x, y) + \rho'_2(x, y)\}\exp \\
&\quad \{-j\gamma[E(x, y) + \sigma_1]\tau_2\} .
\end{aligned}
\right\}
$$

$$
\ldots\ldots \quad (21)
$$

If the processing on and after the equation (4) is conducted by use of $P_1(x, y)$ and $P_2(x, y)$, the underlined portion of the equation (8) takes 1 (one) or a desired separation image $T(x, y)$ can be obtained without performing the processing on and after the equation (10).

As is apparent from the foregoing explanation, the above-mentioned method of eliminating $\theta_{off}$ involves an increased measurement time since the measurement by the conventional multi-echo sequence in which $\tau_1$ and $\tau_2$ in Fig. 1 are 0 is required in addition to the measurement of data for chemical shift imaging. However, the measurement by the conventional multi-echo sequence enables to make a measurement with pixels (or, more particularly, encode values to be altered) the number of which is small as compared with those in the measurement of data for chemical shift imaging and hence an undue increase of the overall measurement time for the object to be examined can be avoided.

The above-mentioned offset phase eliminating method following the conventional multi-echo sequence is similarly applicable to the method shown in Fig. 5 in which the homogeneous phantom is used. In this case, the measurement by the conventional multi-echo sequence is performed for not only the object to be examined but also the homogeneous phantom, $\theta_1'$ and $\theta_2'$ in the equation (3) and $\theta_r$ and $\theta_r'$ in the equation (15) are eliminated in a manner shown by the equation (21) and the processing on and after the equation (16) is performed.

**Claims**

1. A multi-echo NMR imaging method comprising:

A) a first step (101, 201) of obtaining first and second two-dimensional spin data sets by inserting an object to be examined in an inspection zone to which a static magnetic field is applied and performing an NMR measurement sequence including the following steps:

(a) exciting spins of the object to be examined;
(b) applying a phase encoding gradient to the static magnetic field according to a time-intensity program;
(c) sequentially applying first and second 180° RF pulses to the object to generate first and second Hahn echoes;
(d) applying a read-out gradient to the static magnetic field to generate first and second gradient echoes, corresponding to the first and the second Hahn echoes, respectively, and measuring the first and the second gradient echoes, wherein a first time difference ($2\tau_1$) between the first Hahn echo and the first gradient echo provides two chemical shifts ($\sigma_i$, $\sigma_2$) of the spins in the object with a predetermined phase difference ($\theta_1$) other than $n\pi$ (where n is an integer), and a second time difference ($2 (\tau_2 - \tau_1)$) between the second Hahn echo and the second gradient echo provides the two chemical shifts with a phase difference ($\theta_2$) of $2 n\pi$ and
(e) repeating the steps (a) to (d) a plurality of times with a phase encoding gradient according to the time-intensity program to obtain the first and second spin data sets, respectively, representing the first and second gradient echo measured through the repetitions;

B) a second step (102, 202) of obtaining first ($S_1$) and second ($S_2$) image data by effecting two-dimensional Fourier transformation respectively on the first and the second two-dimensional spin data sets;

**characterised by**

C) a third step (203) of obtaining third and fourth two-dimensional spin data sets by inserting a phantom having one of the two chemical shifts in the inspection zone and performing the same NMR measurement sequence i.e. steps Aa - Ae;
D) a fourth step (204) of obtaining third ($U_1$) and fourth ($U_2$) image data by performing two-dimensional Fourier transformation respectively on the third and fourth two-dimensional spin data sets;
E) a fifth step (205) of obtaining fifth ($S_1'$) and sixth ($S_2'$) image data by eliminating phase error distributions due to an inhomogeneity ($E_{st}$) of the static magnetic field from the first and second image data, respectively, using phase distributions of the third and the fourth image data as respective compensation data; and
F) a sixth step (103-105, 206-208) of obtaining seventh image data (R) including spin distribution information of the two chemical shifts ($\sigma_i$, $\sigma_2$) by eliminating from the fifth image data a phase error distribution due to a magnetic permeability distribution ($E_{per}$) of the object by using a phase distribution ($\theta_2''$) calculated from the sixth image data as compensation data.

2. The method of claim 1, wherein the phantom has a larger section than the object and uniformly contains a substance exhibiting only one of the two chemical shifts of the object.

3. The method of claim 1 or 2, further comprising a step (106, 107) of eliminating an offset phase ($\theta_{off}$) which does not depend upon positions of the seventh image data (R).

4. The method of claim 3, wherein the offset phase to be eliminated is detected from the phase of the data of a pixel of the seventh image data (R) at which only one of the chemical shifts exists.

**Patentansprüche**

1. Multi-Echo Kernspinresonanz (NMR)-Abbildungsverfahren, bei dem:

A) in einem ersten Schritt (101, 201) eine erste und eine zweite Gruppe zweidimensionaler Spindaten erzeugt werden, indem das zu untersuchende Objekt in ein in einem statischen Magnetfeld liegendes Untersuchungsgebiet eingebracht wird und anschließend eine NMR-Meßsequenz anhand der folgenden Schritte ausgeführt wird:

(a) Anregen der Spins des zu untersuchenden Objekts;
(b) Anlegen eines phasencodierenden Gradientenfeldes auf das statische Magnetfeld gemäß einem Zeit-Intensitätsprogramm;

(c) Erzeugen von aufeinanderfolgenden ersten und zweiten 180° Hochfrequenzpulsen im Objekt zur Erzeugung erster und zweiter Hahn-Echos;

(d) Anlegen eines Meßgradientenfeldes auf das statische Magnetfeld zur Erzeugung von ersten und zweiten Gradientenechos, entsprechend den ersten und zweiten Hahn-Echos, Ausmessen der ersten und zweiten Gradientenechos, wobei eine erste Zeitdifferenz ($2\tau_1$) zwischen erstem Hahn-Echo und erstem Gradientenecho zwei chemische Verschiebungen ($\sigma_1$, $\sigma_2$) der Spins im Objekt mit einer vorgegebenen Phasendifferenz ($\theta_1$) liefert, die ungleich $n\pi$ ist (n = ganzzahlig), und eine zweite Zeitdifferenz ($2 \cdot (\tau_2 - \tau_1)$) zwischen zweitem Hahn-Echo und zweitem Gradientenecho die beiden chemischen Verschiebungen mit einer Phasendifferenz ($\theta_2$) von 2 $n\pi$ liefert, und

(e) mehrmaliges Wiederholen der Schritte (a) bis (d) mit einem phasencodierenden Gradientenfeld gemäß dem Zeit-Intensitätsprogramm, um die erste und zweite Gruppe von Spindaten zu erhalten, die das erste und zweite Gradientenecho darstellen, das bei diesen Wiederholungen aufgenommen wurde; weiterhin

B) in einem zweiten Schritt (102, 202) erste ($S_1$) und zweite ($S_2$) Bilddaten gewonnen werden, indem auf die erste bzw. zweite Gruppe zweidimensionaler Spindaten eine zweidimensionale Fourier-Transformation angewandt wird;

**dadurch gekennzeichnet,** daß

C) in einem dritten Schritt (203) eine dritte und vierte Gruppe zweidimensionaler Spindaten erzeugt werden, indem ein eine der beiden chemischen Verschiebungen aufweisendes Phantom in das Untersuchungsgebiet eingebracht und dieselbe NMR-Meßsequenz, d.h. die Schritte A(a) bis A(e), ausgeführt wird;

D) in einem vierten Schritt (204) dritte ($U_1$) und vierte ($U_2$) Bilddaten durch Anwendung einer zweidimensionalen Fourier-Transformation auf die dritte und vierte Gruppe zweidimensionaler Spindaten gewonnen werden;

E) in einem fünften Schritt (205) fünfte ($S_1'$) und sechste ($S_2'$) Bilddaten gewonnen werden, indem die durch die Inhomogenität ($E_{St}$) des statischen Magnetfelds bedingten Verteilungen des Phasenfehlers aus den ersten und zweiten Bilddaten beseitigt werden, wobei die Phasenverteilungen der dritten bzw. vierten Bilddaten als zugeordnete Kompensationsdaten verwendet werden; und

F) in einem sechsten Schritt (103-105, 206-208) siebte Bilddaten (R) einschließlich der Information über die Spinverteilung der beiden chemischen Verschiebungen ($\sigma_1$, $\sigma_2$) gewonnen werden, indem die Verteilung des Phasenfehlers aufgrund der magnetischen Permeabilitätsverteilung ($E_{per}$) im Objekt aus den fünften Bilddaten entfernt wird, wobei als Kompensationsdaten die aus den sechsten Bilddaten berechnete Phasenverteilung ($\theta_2''$) verwendet wird.

2. Verfahren nach Anspruch 1, dadurch gekennzeichnet, daß das Phantom einen größeren Querschnitt als das Objekt aufweist und eine gleichmäßig verteilte Substanz beinhaltet, die nur eine der beiden chemischen Verschiebungen des zu untersuchenden Objekts aufzeigt.

3. Verfahren nach einem der Ansprüche 1 oder 2, dadurch gekennzeichnet, daß als weiterer Schritt (106, 107) die Beseitigung einer Offset-Phase ($\theta_{off}$), die von den Positionen der siebten Bilddaten (R) unabhängig ist, vorgesehen ist.

4. Verfahren nach Anspruch 3, dadurch gekennzeichnet, daß die zu beseitigende Offset-Phase aus der Phase der den siebten Bilddaten (R) zugeordneten Pixeldaten entnommen wird, in denen nur eine der chemischen Verschiebungen vorhanden ist.

**Revendications**

1. Procédé d'imagerie RMN multi-écho comportant :

A) une première étape (101, 201) consistant à obtenir des premier et deuxième ensembles de données de spin bidimensionnelles en insérant un objet à examiner dans une zone d'inspection où est appliqué un champ magnétique statique, et à effectuer une séquence de mesures RMN comportant les étapes consistant à :

(a) exciter les spins de l'objet à examiner,
(b) appliquer un gradient de codage de phase au champ magnétique statique en fonction d'un programme temps-intensité,

(c) appliquer de manière séquentielle des première et seconde impulsions H.F 180° à l'objet pour engendrer des premier et second échos de Hahn,

(d) appliquer un gradient de lecture au champ magnétique statique pour engendrer des premier et second échos de gradient, correspondant aux premier et second échos de Hahn, respectivement, et mesurer les premier et second échos de gradient, dans lequel une première différence de temps ($2\tau_1$) entre le premier écho de Hahn et le premier écho de gradient fournit deux décalages chimiques ($\sigma_1$, $\sigma_2$) des spins, dans l'objet, avec une différence de phase prédéterminée ($\theta_1$) autre que $n\pi$ (où n est un nombre entier), et une seconde différence de temps ($2 \times (\tau_2 - \tau_1)$) entre le second écho de Hahn et le second écho de gradient fournit les deux décalages chimiques avec une différence de phase ($\theta2$) de 2 $n\pi$ et

(e) répéter les étapes (a) à (d) plusieurs fois avec un gradient de codage de phase, conformément au programme temps-intensité, pour obtenir les premier et deuxième ensembles de données de spin, respectivement, représentant les premier et second échos de gradients mesurés via les répétitions,

B) une deuxième étape (102, 202) consistant à obtenir des premières ($S_1$) et secondes ($S_2$) données d'image en effectuant une transformation de Fourier bidimensionnelle respectivement sur les premier et deuxième ensembles de données de spin bidimensionnelles,

caractérisé en ce qu'il comporte

C) une troisième étape (203) consistant à obtenir des troisième et quatrième ensembles de données de spin bidimensionnelles en insérant un fantôme ayant l'un des deux décalages chimiques dans la zone d'inspection, et à effectuer la même séquence de mesures RMN, c'est-à-dire les étapes A(a) à A(e),

D) une quatrième étape (204) consistant à obtenir des troisièmes ($U_1$) et quatrièmes ($U_2$) données d'image en effectuant une transformation de Fourier bidimensionnelle respectivement sur les troisième et quatrième ensembles de données de spin bidimensionnelles,

E) une cinquième étape (205) consistant à obtenir des cinquièmes ($S_1'$) et sixièmes ($S_2'$) données d'image en éliminant des premières et deuxièmes données d'image les distributions d'erreurs de phase dues à une non-homogénéité ($E_{st}$) du champ magnétique statique, respectivement, en utilisant les distributions de phase des troisièmes et quatrièmes données d'image en tant que données de compensation respectives, et

F) une sixième étape (103 à 105, 206 à 208) consistant à obtenir des septièmes données d'image (R) incluant des informations de distribution de spins des deux décalages chimiques ($\sigma_1$, $\sigma_2$) en éliminant des cinquièmes données d'image une distribution d'erreurs de phase due à une distribution de perméabilité magnétique ($E_{per}$) de l'objet en utilisant une distribution de phase ($\theta_2''$) calculée à partir des sixièmes données d'image en tant que données de compensation.

2. Procédé selon la revendication 1, dans lequel le fantôme a une section supérieure à celle de l'objet et contient de manière uniforme une substance présentant uniquement l'un des deux décalages chimiques de l'objet.

3. Procédé selon la revendication 1 ou 2, comportant en outre une étape (106, 107) qui consiste à éliminer un déphasage ($\theta_{off}$) qui ne dépend pas des positions des septièmes données d'image (R).

4. Procédé selon la revendication 3, dans lequel le déphasage à éliminer est détecté à partir de la phase des données d'un pixel des septièmes données d'image (R) pour lesquelles seul l'un des décalages chimiques existe.

FIG. IA — RF MAGNETIC FIELD

FIG. IB — SLICE SELECTING FIELD GRADIENT

FIG. IC — ENCODING FIELD GRADIENT

FIG. ID — READ-OUT FIELD GRADIENT

FIG. IE — NMR SIGNAL

FIG. IF — SAMPLING

EP 0 390 175 B1

# F I G. 2

```
101 ── MEASURE SIGNAL
        DATA OF OBJECT

102 ── PERFORM TWO-
        DIMENSIONAL FAST
        FOURIER
        TRANSFORMATION

103 ── DETERMINE PHASE
        DISTRIBUTION
        Ⓗ₂(x,y) OF S₂(x,y)

104 ── CALCULATE PHASE
        ERROR DISTRIBUTION IN
        S₁(x,y) FROM Ⓗ₂(x,y)
        ── S(x,y)

105 ── ELIMINATE PHASE ERROR
        DISTRIBUTION (MAGNETIC
        FIELD INHOMOGENEITY)
        FROM S₁(x,y)

106 ── CALCULATE OFFSET
        PHASE FROM
        COORDINATE POINT
        WHERE ρ₁=0 & ρ₂≒0
        OR ρ₁≒0, ρ₂=0

107 ── ELIMINATE OFFSET
        PHASE FROM R(x,y)
        TO OBTAIN DESIRED
        RESULT
```

# F I G. 3

# F I G. 4

# F I G. 5

201 — MEASURE SIGNAL DATA OF OBJECT

202 — PERFORM TWO-DIMENSIONAL FAST FOURIER TRANSFORMATION

203 — MEASURE SIGNAL DATA OF PHANTOM

204 — PERFORM TWO-DIMENSIONAL FAST FOURIER TRANSFORMATION

205 — ELIMINATE INFLUENCE OF EXTERNAL FIELD INHOMOGENEITY FROM $S_1(x,y)$ BY USE OF $U_1(x,y)$ AND SIMILARLY ELIMINATE INFLUENCE OF EXTERNAL FIELD INHOMOGENEITY FROM $S_2(x,y)$ BY USE OF $U_2(x,y)$

206 — CALCULATE PHASE DISTRIBUTION $\widehat{H}''(x,y)$ OF $S'_2(x,y)$

207 — CALCULATE PHASE ERROR DISTRIBUTION IN $S'_1(x,y)$ FROM $\widehat{H}''_2(x,y) \rightarrow S'(x,y)$

208 — ELIMINATE PHASE ERROR DISTRIBUTION (CHANGE IN MAGNETIC FLUX DENSITY) FROM $S'_1(x,y)$

PERFORM THE SAME STEPS AS STEPS 106 AND 107 OF FIG. 2